# EUROPEAN PATENT APPLICATION

(11) **EP 3 067 917 A1**
(43) Date of publication of application: **14.09.2016**
(21) Application number: 15158411.7
(22) Date of filing: 10.03.2015
(51) Int. Cl.: H01L 21/027, H01L 21/033, H01L 21/3213

(54) **A process for forming an aperture in a pattern layer**

(71) Applicant: IMEC VZW, 3001 Leuven (BE)
(72) Inventor: de Marneffe, Jean-Francois, 3001 Leuven (BE); Souriau, Laurent, 3001 Leuven (BE); Adelmann, Christoph, 3001 Leuven (BE)
(74) Representative: Awapatent AB

(57) **Abstract**

According to an aspect of the present inventive concept there is provided a process for forming an aperture in a pattern layer, comprising:
forming a mask above the pattern layer using a lithography process, wherein the mask includes at least one mask portion,
reducing lateral dimensions of each of said at least one mask portions in a trimming process to form a reduced mask,
depositing by atomic layer deposition, ALD, a metal oxide film selectively on exposed surface portions of the pattern layer,
removing the reduced mask, and
forming at least one aperture in the pattern layer by etching at least one exposed surface portion of the pattern layer while using the metal oxide film as an etch mask.

## Description

### Technical field

The present inventive concept relates to a process for forming an aperture in a pattern layer.

### Background

To overcome resolution limitations of some lithography techniques in connection with forming patterns, such as apertures, in layers during fabrication of semiconductor devices, techniques have been developed for reducing the critical dimensions (CDs) of patterns in patterned resists. This may be referred to as pattern shrinking. For example, in connection with photo lithography pattern shrinking may be achieved by modifying the shape of the patterned photo resist after development and prior to transferring the developed pattern to an underlying layer. Plasma polymers may for example be deposited preferentially on the photoresist side walls using a cyclic etch and re-deposition process. A drawback with this approach is however that it may be difficult to obtain accurate control of the sidewall growth. It is also possible to use resist flow methods such as Resolution Enhancement Lithography Assisted by Chemical Shrink (RELACS). A drawback with this approach is however that the degree of shrinking is limited. Moreover, both plasma polymers and RELACS polymers may be sensitive to subsequent etching processes and thus limit the fidelity of the pattern transfer.

An alternative prior art approach is to, instead of modifying a patterned resist, use a dual hardmask approach and pattern a SiOC top mask with a slope (also known as "tapered SiOC approach"). A drawback with this approach is however that the CD reduction is limited by the angle of the slope, which in turn is limited by the thickness of the top mask.

### Summary of the inventive concept

In view of the above, an objective of the present inventive concept is to provide a process enabling forming of apertures with reduced critical dimensions. A more specific objective is to enable forming of apertures with critical dimensions smaller than resolution limits set by the lithographic process.

According to an aspect of the present inventive concept there is provided a process for forming an aperture in a pattern layer, comprising:
forming a mask above the pattern layer using a lithography process, wherein the mask includes at least one mask portion,
reducing lateral dimensions of each of said at least one mask portions in a trimming process to form a reduced mask,
depositing by atomic layer deposition (ALD) a metal oxide film selectively on exposed surface portions of the pattern layer,
removing the reduced mask, and
forming at least one aperture in the pattern layer by etching at least one exposed surface portion of the pattern layer while using the metal oxide film as an etch mask

The inventive process enables formation of apertures with reduced critical dimensions. In particular, the inventive process enables formation of apertures with critical dimensions smaller than resolution limits set by the lithographic process used for forming the mask. A trim rate of the trimming process may generally be accurately controlled, thereby allowing critical dimensions of the mask to be reduced or "trimmed" to lateral dimensions below the limitations set by the lithography process used for defining the mask.

During the ALD, the reduced mask prevents formation of the metal oxide film on surface portions of the pattern layer covered by the mask. Also, by virtue of being selective, the ALD will also leave the reduced mask exposed, i.e. not covered by the metal oxide film. The mask may thus be conveniently removed without any separate preceding process for exposing the reduced mask. Subsequent to removing the reduced mask, surface portions previously covered by the reduced mask, and not being covered by the metal oxide film, become exposed.

By virtue of the ALD, the metal oxide film may be formed as a conformal film on exposed portions of the pattern layer with an accurately controlled thickness. A metal oxide film may be highly etch-resistant, thereby allowing high-fidelity pattern transfer to an underlying layer. By using the metal oxide film as an etch mask, regions of the pattern layer covered by the metal oxide film are protected from the etching process used for forming the aperture(s) in the pattern layer.

The mask may be formed to include more than one mask portion, which portions are distributed in relation to each other above the horizontally extending pattern layer. In particular the more than one mask portions may form discrete or disconnected mask portions.

The metal oxide film deposited by ALD may be formed by a binary metal oxide. One monolayer of a binary metal oxide may be deposited in a two-cycle deposition process. In particular, the metal oxide film may be formed by Al₂O₃ or HfO₂.

A precursor in the ALD may be H₂O. This enables high selectivity of the metal oxide film deposition to be obtained. Surface portions of the pattern layer exposed to the ALD may be arranged to be hydrophilic and surface portions of the reduced mask exposed to the ALD may be arranged to be hydrophobic wherein the metal oxide film may form selectively on the pattern layer.

The pattern layer may form a hard mask layer. The pattern layer may be formed by a dielectric material composition.

The method may further comprise, subsequent to the trimming process, subjecting the reduced mask to a hydrophobic treatment. Thereby, surface portions of the reduced mask may be provided with hydrophobic properties, or inherent hydrophobic properties of surface portions of the reduced mask which may have been lost or reduced during the trimming process, may be recovered or restored. Thereby, the selectivity of the ALD of the metal oxide film may be advantageously increased.

The pattern layer may include a composition of silicon and oxygen or silicon, oxygen and carbon. Such compositions enable formation of low-k dielectric layers. In particular, the pattern layer may include a silicon oxycarbide (SiOC) composition or a silicon dioxide (SiO₂) composition.

A pattern film may be arranged on a target layer and said pattern layer may be arranged on the pattern film. The target layer may form a substrate. A pattern film may act as an etch-stop during etching of the aperture(s) in the pattern layer. This may be particularly advantageous in case the substrate is sensitive to the etch process used for etching the pattern layer. Accordingly the pattern film may be arranged to allow the pattern layer to be selectively etched off the pattern film.

The pattern film may include an amorphous carbon composition. An amorphous carbon pattern film may advantageously be combined with a pattern layer including a composition of silicon and oxygen or silicon, oxygen and carbon, such as SiOC or SiO₂ wherein the aperture in the pattern layer may be formed by selectively etching the pattern layer off the pattern film.

The method may further comprise forming at least one aperture in the pattern film by etching portions of the pattern film exposed in said at least one aperture in the pattern layer.

According to one embodiment the mask includes a patterned resist layer and wherein the trimming process is a plasma trimming process. Patterned resist layers may be efficiently and inexpensively formed using conventional lithographic processes and trimmed with a high degree of control by controlling the properties of the plasma. The thusly formed mask may be referred to as a "patterned resist mask".

The (patterned) resist mask may be formed by depositing a resist layer above the pattern layer and patterning the resist layer to form said (patterned) resist mask. The resist layer may include a polymer composition.

The process may further comprise depositing an antireflective coating on the pattern layer, depositing a resist layer on the antireflective coating and patterning the resist layer to form said mask, and prior to the ALD of the metal oxide film, removing portions of the antireflective coating which are exposed by the mask or the reduced mask. An antireflective coating may improve the resolution of the exposure by reducing optical reflections. The antireflective coating may in particular be formed by a bottom antireflective coating (BARC). The antireflective coating may be an organic antireflective coating or BARC. The removing of the exposed portions of the antireflective coating may be performed prior to or subsequent to the trimming process. In case of removing the exposed portions of the antireflective coating prior to the trimming process, the trimming process may reduce lateral dimensions of both the mask portions and remaining portions of the antireflective coating.

Subsequent to the ALD of the metal oxide film, the reduced (resist) mask may be removed from the pattern layer in a dry etch. If an antireflective coating is present both the reduced mask and the antireflective coating (i.e. (remaining portions thereof) may be removed simultaneously in a single strip process, e.g. using an O₂-based dry etch.

The process may further comprise, subsequent to the plasma trimming process, subjecting the mask to a hydrophobic treatment. The plasma may be an H₂-based plasma. Thereby any hydrophobic properties inherent to the resist mask (and the optional antireflective coating) which may have been reduced during the trimming process may be recovered or restored. Alternatively, provided the resist mask (and the optional antireflective coating) lack inherent hydrophobic properties the hydrophobic treatment may cause their exposed surface portions to be provided with hydrophobic properties. Thereby, the selectivity of the ALD of the metal oxide film may be advantageously increased.

According to one embodiment the mask includes a patterned polysilicon layer. Compared to other mask materials, such as resist-based masks, a polysilicon layer may be less affected by higher temperature processes. Hence, using the patterned polysilicon layer as a mask may broaden the temperature process window for the ALD process.

The patterned polysilicon layer (i.e. the polysilicon mask) may be formed by depositing a polysilicon layer on the pattern layer and patterning the polysilicon layer to form said mask wherein the pattern layer is exposed. A preliminary polysilicon mask may thus be formed using established lithography processes, which preliminary polysilicon mask subsequently may be trimmed to form a reduced final polysilicon mask having a reduced footprint on the pattern layer.

For example, the polysilicon mask may be formed using a lithography process by: depositing a resist layer above the polysilicon layer, patterning the resist layer, etching off portions of the polysilicon layer exposed by the patterned resist layer, and removing the patterned resist layer wherein remaining portions of the polysilicon layer forms said mask. Optionally, an antireflective coating may be deposited on the polysilicon layer wherein the resist layer subsequently may be deposited on the antireflective coating. An antireflective coating may improve the resolution of the exposure by reducing optical reflections. The antireflective coating may in particular be formed by a BARC.

The trimming process for the polysilicon mask may include performing dry oxidation of the polysilicon mask. The dry oxidation may gradually transform the polysilicon mask to SiO₂, in an inward direction of the mask. The dry oxidation thus enables a reduced polysilicon mask to be formed by subsequent removal of the SiO₂. Dry oxidation enables trimming by virtue of a high degree of control of the thickness of the oxide formed by controlling the oxidation process parameters.

The trimming process may further include, subsequent to the dry oxidation, removing any SiP₂ formed on the mask by etching to form the reduced mask. The etching may also remove SiO₂ formed on the pattern layer during the dry oxidation. This is advantageous since SiO₂ formed on the pattern layer may otherwise reduce the hydrophilic properties of the pattern layer.

The SiO₂ may be removed in an HF-based etch process providing the reduced mask with hydrophobic properties (e.g. at least hydrophobic surface portions), in other words causing the reduced mask to become hydrophobic. A hydrophobic treatment of the reduced mask may thus be performed in a same process step as the removal of the SiO₂. Thereby, the selectivity of the ALD of the metal oxide film may be advantageously increased. Especially, by using an HF-based etchant the surface of the reduced polysilicon mask may become hydrogen terminated and thus hydrophobic.

The trimming process may further include, subsequent to the dry oxidation, subjecting the mask to a silylation treatment. By the silylation treatment, a simultaneous removal of oxide formed on the mask (thereby reducing the dimensions of the mask) and hydrophobicity treatment (by a silylation reaction with the oxide) of the mask may be achieved, thereby resulting in a reduced mask with a hydrophobic surface.

The pattern layer may include a material composition having a lower etch rate than silicon dioxide. In particular, the pattern layer may include a SiOC composition. This may be advantageous both in the case of using the HF-based etch process and the silylation treatment.

### Brief description of the drawings

The above, as well as additional objects, features and advantages of the present inventive concept, will be better understood through the following illustrative and non-limiting detailed description of preferred embodiments of the present inventive concept, with reference to the appended drawings. In the drawings like reference numerals will be used for like elements unless stated otherwise.
Figs 1a-e schematically illustrates a first process for forming an aperture in a pattern layer.
Figs 2a-f schematically illustrates a second process for forming an aperture in a pattern layer.

### Detailed description of preferred embodiments

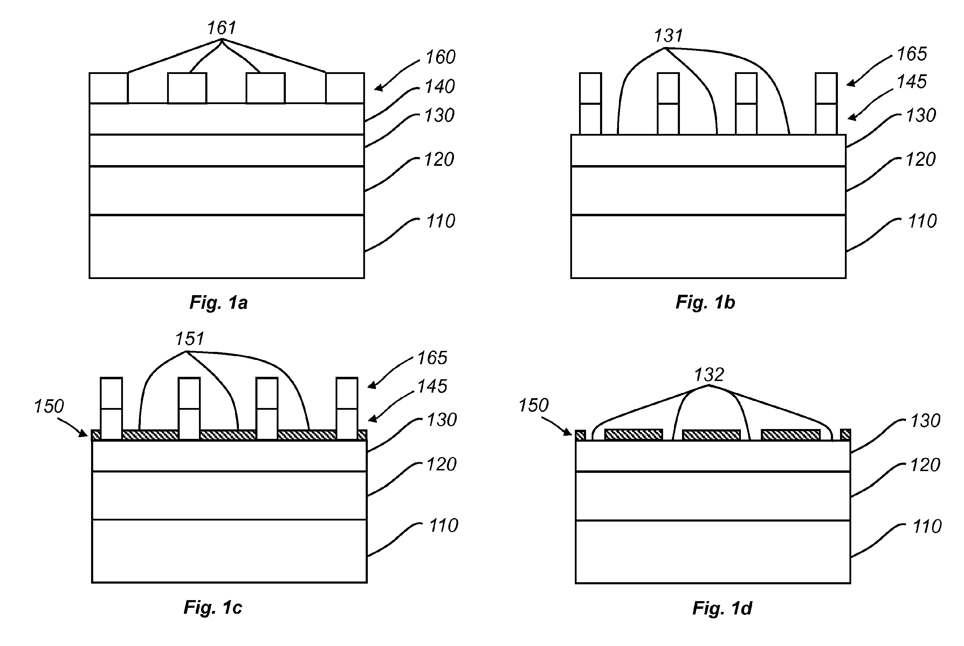

A first process for forming an aperture in a pattern layer will now be described with reference to the Figs 1a-e.

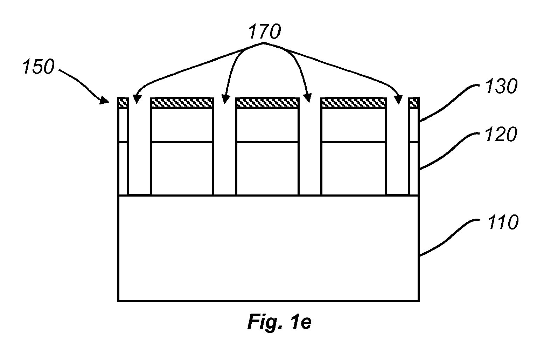

The first process will be described in connection with a layer stack illustrated in Fig. 1 a. In a bottom-up direction, the stack includes a target layer 110. The target layer 110 is the layer which is to be exposed by the apertures formed through the layer stack according to the process. The target layer 110 may for example be a substrate layer on which further features are to be formed by deposition of material compositions in the apertures of the layer stack. The target layer 110 may for example be a silicon-based (Si) substrate such as a silicon on insulator (SOI) substrate. The process is applicable also to other material systems such as a gallium arsenide substrate, a gallium arsenide phosphide substrate, an indium gallium arsenide substrate, a silicon germanium substrate, a silicon on glass substrate, a silicon on sapphire substrate or a germanium on insulator substrate.

The stack further includes a pattern film 120. The pattern film 120 may include amorphous carbon and form an amorphous carbon hard mask. The pattern film 120 may be formed on the target layer 110 using conventional techniques, such as by a spin-coating process or a chemical vapor deposition (CVD) process. An amorphous carbon pattern film may act as an efficient etch-stop during subsequent etching steps, which will be described below, and also enable a high fidelity transfer of a pattern to the target layer 110. For example, the pattern film 120 may be any commercially available Advanced Patterning Film. It should however be noted that the pattern film 120 is optional and that the process is applicable also to stacks which do not include a pattern film 120.

The stack further includes a pattern layer 130. The layer 130 is the layer in which (possibly sub-lithographic) apertures are to be transferred for exposing the pattern film 120 (if any) and finally the target layer 110. The pattern layer 130 may include a material making the pattern layer 130 suitable to act as a hard mask layer. The pattern layer 130 may include a composition which provides the pattern layer 130 with hydrophilic surface properties. One representative example of such a composition is a composition including silicon and oxygen (such as SiO₂). Another example is a composition including silicon, oxygen and carbon (such as SiOC). The pattern layer 130 and the pattern film 120 may together form a dual hard mask including an amorphous carbon hard mask and a SiO₂ or SiOC hard mask. The pattern layer 130 may be formed on the pattern film 120 (or directly on the target layer 110 if the stack includes no pattern film 120) using conventional techniques, such as CVD.

The stack further includes a layer 160. As will be described in the following the layer 160 will be used to form a mask during a subsequent atomic layer deposition (ALD) of a metal oxide film 150 and will therefore be referred to as the mask 160. The mask 160 may be formed by depositing a resist layer, such as a photo resist, in a spin-coating process. Thereafter the resist layer may be patterned in a lithography process to form the mask 160 including one or more mask portions 161. The resist may advantageously be a negative resist wherein only the portions of the resist which are exposed to light become insoluble by the developer. Thus, during exposure the stack need only be subjected to a comparably small amount of light wherein undesired radiation-induced effects may be kept to a minimum. However, it is also possible to use a positive photo resist for forming the mask 160.

In Fig. 1 a the mask 160 will be used to form apertures in the form of holes or vias extending through the layer stack. Thus, the mask 160 includes a plurality of discrete and separate mask portions 161 which are horizontally distributed in relation to each other. However this is only one example and the number of mask portions 161, and their mutual relationship, will depend on the type of pattern which is to transferred to the target layer 110. For example, the mask 160 could also be patterned for the purpose of forming one or more trench-like apertures in the layer stack.

The stack may optionally include an antireflective coating 140 formed on the pattern layer 130, wherein the mask 160 may be formed from a resist layer deposited on the antireflective coating 140. The antireflective coating 140 may for example be an organic bottom antireflective coating (BARC). The antireflective coating 140 may be deposited using conventional techniques, such as by a spin-coating process. If the stack does not include the antireflective coating 140 the mask 160 may be formed from a resist deposited directly on the pattern layer 130.

Following the forming of the mask 160 by patterning the resist, the mask 160 is subjected to a plasma-based trimming process wherein lateral dimensions of each mask portion of the mask 160 are reduced and wherein a reduced or "trimmed" mask 165 is formed, see Fig. 1 b. Accordingly, a footprint of the mask 160 on the antireflective coating 140 (or on the pattern layer 130 if no antireflective coating 140 is present) is reduced. The trimmed mask 165 may hence be provided with lateral dimensions which are smaller than the corresponding lateral dimensions of the mask 160, as defined by the resolution of the lithography process. The trimming process may also reduce the thickness of the mask portions 161 of the mask 160, however since the thickness of the mask 160 generally is greater than the critical lateral dimensions of the mask 160 this does not adversely affect the fidelity of the subsequent pattern transfer. As a non-limiting example, conventional optical lithography processes may allow forming of mask portions 161 having a critical dimension as small as 45 nm. During the trimming process the critical dimensions of the mask portions 161 may be reduced to 15 nm, or even smaller. The trimming process may include subjecting the mask 160 to an O₂-based plasma, such as O₂-Cl₂. The trimming process may include performing an inductively coupled plasma (ICP) reactive-ion etching (RIE), preferably with a substantially zero RF bias applied to the wafer to minimize anisotropy of the trim process. The etching may preferably be performed at a relatively low power to reduce the rate of the trimming process and thus improve the control thereof.

Subsequent to the trimming process portions of the antireflective coating 140 (if present) which are exposed by the reduced mask 165 may be removed by etching while using the trimmed mask 165 as an etch mask, to arrive at the stack configuration shown in Fig. 1b wherein portions 131 of the pattern layer 130 are exposed. The antireflective coating 140 is thus patterned to form a patterned antireflective coating 145. However it is also possible to remove portions of the antireflective coating 140 prior to the trimming process, wherein the removed portions correspond to portions of the antireflective coating 145 which are exposed by the mask 160. The subsequent trimming process may hence simultaneously reduce the lateral dimensions of the mask portions 161 and the remaining portions of the antireflective coating 140.

Once the horizontal surface of the pattern layer 130 has been exposed, the trimmed mask 165 and the patterned antireflective coating 145 (if present) are subjected to hydrophobic treatment. The hydrophobic treatment may include subjecting the trimmed mask 165 and the patterned antireflective coating 145 to an H₂-based plasma, for example an He-H₂ afterglow plasma (preferably at a temperature between 200 °C and 350 °C). In case the trimmed mask 165 and the patterned antireflective coating 145 includes organic material compositions they may already have some inherent hydrophobic properties. However, these hydrophobic properties may be reduced/damaged during the trimming process wherein the hydrophobic treatment may improve or at least restore the inherent hydrophobic properties. The hydrophobic treatment may in that case be referred to as a "hydrophicity repair process". In case the inherent hydrophobic properties remain also following the trimming process, the hydrophobic treatment need not be performed.

Following the hydrophobic treatment, a metal oxide film 150 (including metal oxide film portions 151) is selectively deposited on the exposed horizontal surface portions 131 of the pattern layer 130 by atomic layer deposition (ALD), see Fig. 1 c. The metal oxide film 150 may be formed by a binary metal oxide such as Al₂O₃ or HfO₂. Al₂O₃ may for example be deposited by thermal ALD using trimethylaluminum (TMA) as a first precursor and H₂O as a second precursor. HfO₂ may for example be deposited by thermal ALD using HfCl₄ as a first precursor and H₂O as a second precursor. Other binary metal oxides which may be deposited by ALD using H₂O as a precursor are TiO₂, ZnO, ZrO₂, and Ta₂O₅. A film formed by a binary metal oxide may act as a highly efficient etch stop during subsequent etching. Due to the exposed surfaces of the trimmed mask 165 and the patterned antireflective coating 145 being hydrophobic (e.g. following the hydrophobic treatment) formation of a metal oxide film on the trimmed mask 165 and the patterned antireflective coating 145 will be prevented. On the other hand, by virtue of the surface portions 131 of the pattern layer 130 being hydrophilic (which is the case for SiO₂ and SiOC, among others) one or more mono-layers of the metal oxide may be formed on the pattern layer 130 by the ALD. The ALD may hence be referred to as a selective-ALD process. The trimmed mask 165 hence acts an "ALD mask".

It should be noted that in practice some minor patches of metal oxide may form on the trimmed mask 165 and the patterned antireflective coating 145 however without completely covering the trimmed mask 165 or the patterned antireflective coating 145. Such minor patches (or contaminants) will thus not prevent subsequent removal of the trimmed mask 165 and the patterned antireflective coating 145, as will be described below.

Subsequent to the selective-ALD of the metal oxide film 150, the trimmed mask 165 and the patterned antireflective coating 145 (if present) may be removed by etching, for example by a plasma-based etching process. The etching process may be a capacitively coupled plasma (CCP) RIE or an ICP RIE using an O₂-based plasma. As a specific non-limiting example an etching process may be performed using an N₂-O₂ plasma (e.g. in a CCP RIE process) or O₂-Cl₂ plasma (e.g. in an ICP RIE process). An O₂-based plasma allows the trimmed mask 165 and the patterned antireflective coating 145 to be removed in a same etching process. During the etching, the metal oxide film 150 will act as an etch mask, protecting the pattern layer 130 and underlying layers from being affected by the etching process. By the removal of the trimmed mask 165 and the patterned antireflective coating 145 (if present) exposed surface portions 132 of the pattern layer 130 are formed, see Fig. 1d. In particular the exposed surface portions 132 of the pattern layer 130 are portions being exposed through the openings/apertures in the metal oxide film 150. While using the metal oxide film 150 as an etch mask, apertures 170 may be formed in the pattern layer 130 by etching, see Fig. 1 e. The pattern layer 130 may for example be etched using a CF₄-based plasma etch. The etching process may proceed until the etch stopping pattern film 120 is exposed in the apertures 170 extending through the pattern layer 130. Thereafter, the apertures 170 may be transferred to the pattern film 120. The pattern film 120 may be etched using for example an N₂-H₂ plasma, an N₂-O₂ plasma or an O₂Cl₂ plasma in a RIE process. The etching process may proceed until the target layer 110 is exposed in the apertures 170.

Following formation of the apertures 170 the apertures 170 may for example be filled with a conductor for providing electrical connections to features on or of the target layer 110.

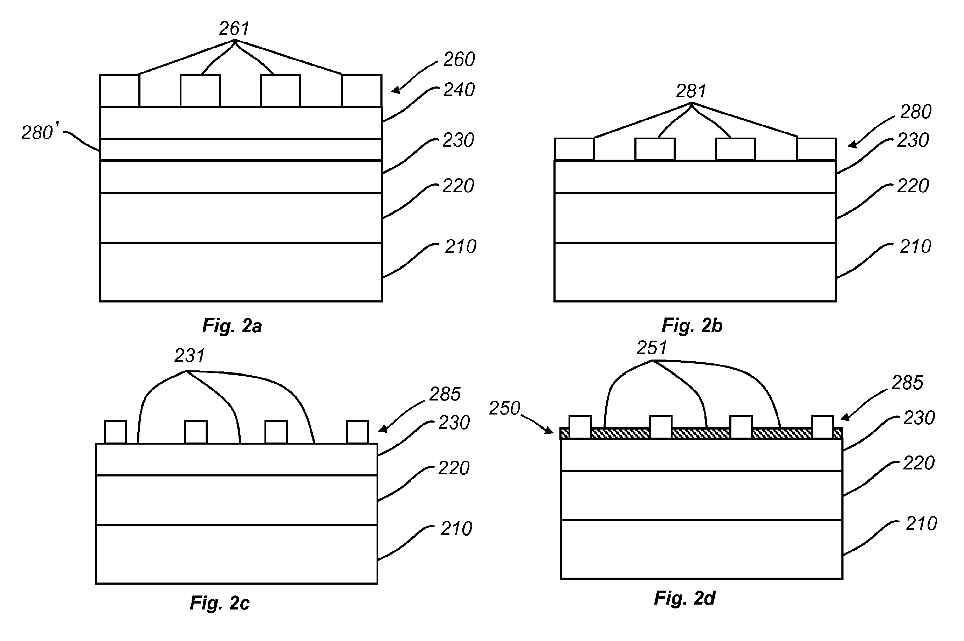

A second process for forming an aperture in a pattern layer will now be described with reference to Figs 2a-e.

The second process will be described in connection with a layer stack illustrated in Fig. 2a. In a bottom-up direction, the stack is similar to the stack in Fig. 1 a and includes a target layer 210, an optional pattern film 220, a pattern layer 230, an optional antireflective coating 240 and a patterned resist 260. In addition to these layers the stack includes a polysilicon layer 280' arranged intermediate the pattern layer 230 and the patterned resist 260 including a number of portions 261.

Following patterning of the resist layer 260 and subsequent opening of the optional antireflective coating 240, exposed horizontal surface portions of the polysilicon layer 280' are patterned by etching while using the patterned resist 260 as an etch mask. The polysilicon layer 280 is etched until the pattern layer 230 is exposed, see Fig. 2b. The polysilicon layer 280 may be etched using a Cl₂-based plasma etch. The thusly patterned polysilicon layer 280 will in the following be referred to as a polysilicon mask 280, including one or more mask portions 281.

Following forming of the polysilicon mask 280 the patterned resist 260 and the antireflective coating 240 (if present) is stripped from the polysilicon layer 280, e.g. using an O₂-based plasma etching process (such as an N₂-O₂ plasma or O₂-Cl₂ plasma).

Thereafter, the mask 280 is subjected to a trimming process including a dry oxidation process and a subsequent etch process arranged to remove any SiO₂ layers formed on the exposed surface portions of the mask 280 during the dry oxidation, thereby forming a reduced mask 285, as illustrated in Fig. 2c. The dry oxidation process is preferably performed at a low temperature (e.g. 600-800 °C). By the trimming process, lateral dimensions of each mask portion 281 of the mask 280 are reduced wherein the reduced or "trimmed" mask 285 is formed. Accordingly, a footprint of the mask 285 on the pattern layer 230 is reduced. The trimmed polysilicon mask 285 may hence be provided with lateral dimensions which are smaller than the corresponding lateral dimensions of the patterned resist 260, as defined by the resolution of the lithography process.

The etch process may be arranged to selectively remove any SiO₂ formed on the polysilicon mask 280 and the pattern layer 230 during the dry oxidation. If the pattern layer 230 is formed from a composition including SiOC, the SiO₂ may be selectively removed in an HF-based etch process, such as an HF-based wet etch (e.g. a buffered oxide etch) or an HF-based vapor etch. By using an HF-based etchant the surface portions of the reduced polysilicon mask 285 may become hydrogen terminated and thus hydrophobic. Furthermore, the HF-based etching may also remove SiO₂ from the pattern layer 230. This may further improve the selectivity of the subsequent ALD. Hence, the etch process may result in forming of a hydrophobicity-treated reduced polysilicon mask 285, and a simultaneous removal of the SiO₂ (formed during the dry oxidation) from the mask 285 and the pattern layer 230. Although, a SiOC pattern layer is provided as an advantageous example above, it should however be noted that other material compositions than SiOC, which have a lower etch rate than silicon dioxide, may be used to form the pattern layer 230.

As an alternative to the HF-based hydrophobicity treatment of the polysilicon, subsequent to the dry oxidation of the polysilicon mask 280, the oxidized polysilicon on the oxidized polysilicon mask may be subjected to a silylation treatment. The silylation treatment may, by reacting with the oxide on the surface of the oxidized polysilicon mask, remove the oxide to form the reduced mask 285 with a hydrophobic surface. By way of example, silylation may transform Si-OH (e.g. formed on the polysilicon surface during the dry oxidation) into Si-O-Si-CH₃.

Following the trimming process, a metal oxide film 250 (including metal oxide film portions 251), similar to the metal oxide film 150, is selectively deposited on the pattern layer 230 by ALD, see Fig. 2d. Due to the exposed surfaces of the trimmed polysilicon mask 285 being hydrophobic, formation of a metal oxide film on the trimmed polysilicon mask 285 will be prevented. On the other hand, by virtue of the exposed surface portions 231 of the pattern layer 230 being hydrophilic (which is the case for SiOC among others) one or more mono-layers of the metal oxide may be formed on the pattern layer 230 by the ALD. The ALD may hence also in the second process be referred to as a selective-ALD process. The trimmed polysilicon mask 285 hence acts an "ALD mask".

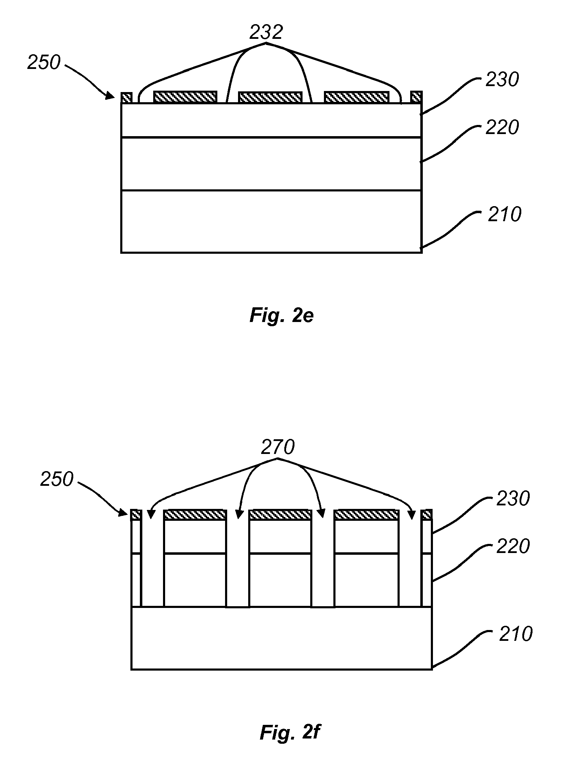

Subsequent to the ALD of the metal oxide film 250, the trimmed polysilicon mask 285 may be removed from the pattern layer 230 by etching, using either a dry or a wet etch process (e.g. using a Cl₂-based etchant), see Fig. 2e. By the removal of the trimmed polysilicon mask 285 exposed surface portions 232 of the pattern layer 230 are formed. In particular the exposed surface portions 232 of the pattern layer 230 are portions being exposed through the openings/apertures in the metal oxide film 250. In analogy with the first process, apertures 270 may thereafter be formed through the pattern layer 230 and the pattern film 220 (if present), see Fig. 2f.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A process for forming an aperture (170, 270) in a pattern layer (130, 230), comprising:
forming a mask (160, 280) above the pattern layer (120, 220) using a lithography process, wherein the mask (160, 280) includes at least one mask portion (161, 281),
reducing lateral dimensions of each of said at least one mask portions (161, 281) in a trimming process to form a reduced mask (165, 285), depositing by atomic layer deposition, ALD, a metal oxide film (150, 250) selectively on exposed surface portions (131, 231) of the pattern layer (130, 230),
removing the reduced mask (165, 285), and
forming at least one aperture (170, 270) in the pattern layer (130, 230) by etching at least one exposed surface portion (132, 232) of the pattern layer (130, 230) while using the metal oxide film (150, 250) as an etch mask.

2. A process according to claim 1, wherein the metal oxide film (150, 250) is formed by a binary metal oxide.

3. A process according to claim 2, wherein the metal oxide film (150, 250) is formed by Al₂O₃ or HfO₂.

4. A process according to any one of claims 1-3, wherein a precursor in the ALD is H₂O.

5. A process according to any one of claims 1-4, wherein surface portions (131, 231) of the pattern layer (130, 230) exposed to the ALD are hydrophilic and surface portions of the reduced mask (165, 285) exposed to the ALD are hydrophobic.

6. A process according to any one of claims 1-5, further comprising, subsequent to the trimming process, subjecting the reduced mask (165, 285) to a hydrophobic treatment.

7. A process according to any one of claims 1-6, wherein the pattern layer (130, 230) includes a composition of silicon and oxygen or silicon, oxygen and carbon.

8. A process according to any of claims 1-7, wherein a pattern film (120, 220) is arranged on a target layer (110, 210) and wherein said pattern layer (130, 230) is arranged on the pattern film (120, 220).

9. A process according to any of claims 1-8, wherein the mask (160) includes a patterned resist layer and wherein the trimming process is a plasma trimming process.

10. A process according to claim 9, wherein forming the mask (160) includes depositing a resist layer and patterning the resist layer to form said mask (160).

11. A process according to claim 9, further comprising:
depositing an antireflective coating (140) on the pattern layer (130),
depositing a resist layer on the antireflective coating (140) and patterning the resist layer to form said mask (160), and
prior to the ALD of the metal oxide film (150), removing portions of the antireflective coating (140) which are exposed by the mask (160) or the reduced mask (165).

12. A process according to any of claims 1-8, wherein the mask (280) includes a patterned polysilicon layer.

13. A process according to claims 12, wherein forming the mask (280) includes depositing a polysilicon layer (280') on the pattern layer (230) and patterning the polysilicon layer (280') to form said mask (280) wherein the pattern layer (230) is exposed.

14. A process according to any of claims 12-13, wherein the trimming process includes performing dry oxidation of the mask (280).

15. A process according to claim 14, wherein the trimming process further includes, subsequent to the dry oxidation, removing SiO₂ formed on the mask (280) to form the reduced mask (285).

16. A process according to claim 15, wherein the SiO₂ is removed in an HF-based etch process providing the reduced mask (285) with hydrophobic properties.
